# EUROPEAN PATENT APPLICATION

(11) **EP 1 840 586 A2**
(43) Date of publication of application: **03.10.2007**
(21) Application number: 07006571.9
(22) Date of filing: 29.03.2007
(51) Int. Cl.: G01R 33/09

(54) **Magnetic sensor having resistance adjusting unit and method of manufacturing the same**

(30) Priority: 30.03.2006 JP 2006094264
(71) Applicant: ALPS ELECTRIC CO., LTD., Tokyo 145-8501 (JP)
(72) Inventor: Sasaki, Yoshito, Tokyo 145-8501 (JP); Sato, Kiyoshi, Tokyo 145-8501 (JP)
(74) Representative: Klunker . Schmitt-Nilson . Hirsch

(57) **Abstract**

Provided are a magnetic sensor capable of properly reducing a deviation of a central potential and a method of manufacturing the magnetic sensor. A conductor 35 is connected to an end of a fixed resistance element 9. The conductor 35 includes a plurality of divisional path pieces 35a to 35d, and a common path piece 35e. A current path length in a longitudinal direction of the conductor 35 (Y direction in the figure) is varied by cutting a part of 35e1 of the common path piece 35e, thereby adjusting the resistance.

## Description

### BACKGROUND OF THE INVENTION

### 1. Field of the Invention

The present application relates to a non-contact magnetic sensor having a magnetoresistance effect element and a fixed resistance element, and more particularly, to a magnetic sensor capable of minimizing a deviation of a central potential and a method of manufacturing the magnetic sensor.

### 2. Description of the Related Art

An example of such a magnetic sensor having a magnetoresistance effect element is disclosed in the following documents.

An external resistance and a magnetoresistance element are provided on a substrate and a deviation of a central potential decreases by trimming the external resistance. An example of such an invention is disclosed in Japanese Unexamined Patent Application Publication No. 4-18778.

A magnetic sensor includes an MR element and a resistive element and a deviation of a central potential decreases by trimming the resistive element. An example of such an invention is disclosed in Japanese Unexamined Patent Application Publication No. 62-293683.

A magnetoresistance effect thin-film is provided on an insulating substrate, a resistive element that is provided under the insulating substrate, the magnetoresistance effect thin-film and the resistive element are connected via a conductive metallization layer which passes through an inside of the insulating substrate and the deviation of the central potential is reduced by trimming the resistive element. An example of such an invention is disclosed in Japanese Unexamined Patent Application Publication No. 8-23129.

In the related arts disclosed in Japanese Unexamined Patent Application Publication No. 4-18778, No. 62-293683, and No. 8-23129, the above-mentioned inventions are all contrived to trim the resistive element. However, the invention does not concretely disclose how to trim and adjust a resistance value. In other words, it is not sure that any part of the resistive element is trimmed into any shape.

In addition, since the trimming of the resistive element is thought to lessen a cross section, it is thought that a resistance value of the resistive element increases. On the contrary, it is not sure how to reduce the resistance value of the resistive element, when it is required to reduce the resistance value of the resistive element.

In addition, since the magnetoresistance element and the resistive element have difference in material, the magnetoresistance element and the fixed resistance are different in temperature coefficient (TCR: Temperature Coefficient of Resistance). As a result, when temperature varies, balance of the central potential is lost and thus detection accuracy is lowered, thereby causing malfunctioning. As a result, when the resistance value of the magnetoresistance element and the resistance value of the resistive element are adjusted so as to reduce a deviation of the central potential in standard state, there is a problem that the deviation of the central potential substantially increases, when a temperature varies from the normal state.

### SUMMARY OF THE INVENTION

The present invention is contrived to solve the above-mentioned problems. An object of the invention is to provide a magnetic sensor capable of appropriately minimizing a deviation of a central potential compared with the related art and also to provide a method of manufacturing the magnetic sensor.

According to an aspect of the application, there is provided a magnetic sensor including at least one magnetoresistance element provided on an element base, at least one fixed resistance element provided on the element base, and terminal portions provided on both sides in a longitudinal direction of the magnetoresistance element and on both sides in a longitudinal direction of the fixed resistance element, wherein a conductor is connected to at least one element of the magnetoresistance element and the fixed resistance element so as to adjust a resistance value between the terminal portions.

Accordingly, the resistance value between the terminal portions may be easily adjusted, whereby it is possible to properly minimizing the deviation of the central potential.

In the application, the conductor may be connected to an end of a high-resistance element which is one of the magnetoresistance element and the fixed resistance element having a high resistance value and the conductor may be formed in a shape in which a current path length is shortened in the longitudinal direction by cutting. The conductor is connected to the high-resistance element in parallel. Since the conductor has lower resistance value than that of the high-resistance value, current flow to the conductor in a position connected to the conductor. Accordingly, it is possible to lower the resistance value between the terminal portions connected to the high-resistance value and to reduce the deviation of the central potential with a high precision. In addition, in the application, since the element does not be trimmed, the element may not be damaged. In addition, in the application, when the high-resistance element connected between the terminal portions by a connection of the conductor decreases more than that of the resistance value connected to other low-resistance element, a current path length in the longitudinal direction is shortened by cutting the conductor and the resistance value between the terminal portions connected to the high-resistance value. Accordingly, it is possible to easily adjust to the resistance value with the high precision.

In the application, the conductor includes at least three cuttable divisional path pieces which come in contact with the high-resistance element with gaps in the longitudinal direction therebetween, and a cuttable common path piece connecting the cuttable divisional path pieces to each other. Accordingly, a shape in which the current path length may be shortened in the longitudinal direction by the cutting can be simply and easily formed. The gaps in the longitudinal direction between the divisional path pieces are different from each other. According to a cutting position of the conductor, an increased amount of resistance value may be determined and the resistance value may be adjusted. In addition, the increased amount of the resistance value may be adjusted in detail.

In the application, a part of a high-resistance element which is one of the magnetoresistance element and the fixed resistance element having a high resistance value is removed to shorten in the longitudinal direction a length is shortened its length in a longitudinal direction and the conductor is provided in the removed part. Accordingly, it is possible to reduce properly the deviation of the central potential with the high precision.

In the application, the magnetoresistance element and the fixed resistance element include an anti-ferromagnetic layer, a plurality of magnetic layers, a non-magnetic layer, and a protection layer serving as an uppermost layer, the magnetoresistance element includes a fixed layer which has at least one magnetic layer and of which magnetization direction is fixed and a free layer which has the other magnetic layers and of which magnetization direction varies with an external magnetic field, the non-magnetic layer is interposed between the fixed layer and the free layer, and the anti-ferromagnetic layer is formed in contact with a surface opposite to the surface of the fixed layer where the non-magnetic is formed; and in the fixed resistance element, the at least one magnetic layer is formed in contact with the anti-ferromagnetic layer, and the magnetization directions of all the magnetic layers are fixed.

In the above-mentioned application, the anti-ferromagnetic coupling layer, a plurality of magnetic layers, the non-magnetic layer, and the protection layer are used as a constitution layer of the magnetoresistance element and the fixed resistance. In addition, in the application, a lamination order of the constitution layer by using the magnetoresistance element and the fixed resistance varies, the magnetoresistance element exhibits properly the magnetoresistance element on the basis of the external magnetic variation, and the magnetoresistance element serves as a variation resistance in which the variation varies. Meanwhile, in the fixed resistance, the magnetization of the magnetic layer is fixed in one direction. Accordingly, when the external magnetic field varies, the magnetoresistance element may not be exhibited in a manner different from the magnetoresistance element.

In the above-mentioned application, since the magnetoresistance and the fixed resistance includes the anti-ferromagnetic layer, a plurality of magnetic layer, and the protection layer as the constitution layer, it is possible to suppress the difference between the temperature coefficient of the magnetoresistance element and the temperature coefficient. As a result, it is possible to reduce a deviation of the central potential.

In addition, in the application, the magnetoresistance element and the fixed resistance element may have an anti-ferromagnetic layer, a fixed layer which is formed in contact with the anti-ferromagnetic layer and of which a magnetization direction is fixed, and a free layer which is opposed to the fixed layer with a non-magnetic layer therebetween, and of which the magnetization directions vary in accordance with the external magnetic field, and wherein an interlayer coupling magnetic field Hin acting between the free layer and the fixed layer of the fixed resistance element is larger than an interlayer coupling magnetic field Hin acting between the free layer and the fixed layer of the magnetoresistance element.

Accordingly, although the fixed layer and the free layer are provided like the fixed resistance element and the fixed resistance element, the interlayer coupling magnetic field Hin is larger than the interlayer coupling of the magnetoresistance element. Accordingly, the fixed resistance element may properly function as the fixed resistance within an allowable range of an external magnetic field. As above-mentioned, while a temperature coefficient (TCR) slightly varies by varying a film thickness of the non-magnetic layer in the magnetoresistance element and the fixed resistance element in order to alter the interlayer coupling magnetic field Hin of the magnetoresistance element and the fixed resistance element, it is possible to reduce the deviation of the temperature coefficient of the magnetoresistance element and the fixed resistance element properly than when the fixed resistance element is formed by a completely different constitution layer, compared with the magnetoresistance element.

In addition, for example, as mentioned above, when the length is shortened after removing a part of the element, magnitude of the interlayer coupling magnetic field Hin does not vary and the coercive force Hc does not depend on the longitudinal. Accordingly, since a hysteresis characteristic of the magnetoresistance element and the fixed resistance element does not vary, the hysteresis characteristic gives secure operation.

In a method of manufacturing the magnetic sensor of the application, the method will be explained hereinafter.

According to another aspect of the application, there is provided a method of manufacturing a magnetic sensor including the steps of:
(a) forming a plurality of sets, each of which includes at least a magnetoresistance element and a fixed resistance, on a substrate and,
(b) forming terminal portions on both sides in a longitudinal direction of the magnetoresistance element and on both sides in the longitudinal direction of the fixed resistance element,
(c) connecting a conductor to a high-resistance element which is one of the magnetoresistance element and the fixed resistance element having a high resistance value so as to set a resistance value between the terminal portions connected to the high-resistance element within an allowable range of a resistance value between the terminal portions connected to a low-resistance element.
(d) cutting the substrate every set, between the process (b) and the process (c), or after the process (c).

In the above-mentioned application, since it is possible to easily adjust the resistance value between terminal portions with high precision, it possible to manufacture the magnetic sensor which reduces the deviation of the central potential.

In the application, in the process (c), the conductor connected to the high-resistance element may have such a shape that a current path length may be shortened in the longitudinal direction by cutting. In the process (c) includes a first sub-process of setting the resistance value between the terminal portions connected to the high-resistance element to be lower than the resistance value between the terminal portions connected to the low-resistance element at the time of connecting the conductor, and a second sub-process of cutting a part of the conductor to shorten a current path length in the longitudinal direction of the conductor and thus to increase the resistance value between the terminal portions connected to the high-resistance element, wherein the second sub-process is repeated until the resistance value between the terminal portions connected to the high-resistance element is within the allowable range. Accordingly, it is possible to adjust easily the resistance between the terminal portions with the high precision.

In addition, in the application, the conductor may have at least three cuttable divisional path pieces in contact with the high-resistance element with gaps therebetween in the longitudinal direction and a cuttable common path piece connecting the divisional path pieces, and the divisional path pieces or the common path piece is cut or the divisional path pieces and the common path piece are cut in the second sub-process of the (c) process. In addition, the gaps in the longitudinal direction between the divisional path pieces may have different lengths in the longitudinal direction, a cutting position of the divisional path piece or the common path piece may be determined or cutting positions of the divisional path piece and the common path piece may be determined in accordance with an increased amount of resistance value necessary for the second sub-process of the process (c).

In addition, in the application, in the process (c), a part of the high-resistance element is removed to shorten a length in the longitudinal direction of the high-resistance element and the conductor is formed in the removed part to decrease a resistance value between the terminal portions connected to the high-resistance element lower than the resistance value before removing the part of the high-resistance element. Accordingly, the resistance value between the terminal portions connected to the high resistance element may be within the allowable range.

In the magnetic sensor of the application, since the adjustment of the resistance value between the terminal portions may be easily performed, it is possible to reduce the deviation of the central potential. In addition, it is possible to reduce the non-uniform of the central potential in accordance with the variation of the temperature.

### BRIEF DESCRIPTION OF THE DRAWINGS

Fig. 1 is a partially schematic diagram illustrating a foldable cellular phone with a built-in magnetic sensor according to an embodiment (closed state).
Fig. 2 is a partially schematic diagram illustrating a foldable cellular phone with a built-in magnetic sensor according to an embodiment (opened state) of the application.
Fig. 3 is a partially top plan view illustrating a magnetic sensor according to the embodiment of the application.
Fig. 4 is a partial and cross sectional view illustrating the magnetic sensor taken along a line A-A of Fig.3, viewed from an arrow direction in Fig. 3.
Fig. 5A is a partially enlarged top plan view illustrating the magnetic sensor before cutting a conductor. Fig. 5B is a partially enlarged top plan view illustrating after cutting the conductor.
Fig. 6 is a partially enlarged top plan view illustrating the magnetic sensor with a structure different from that shown in Fig. 5A and 5B according to the embodiment of the application.
Fig. 7 is a partially enlarged top plan view illustrating the magnetic sensor with a structure different from that shown in Fig. 5A, Fig. 5B, and Fig. 6 according to the embodiment of the application.
Fig. 8 is a partially enlarged cross-sectional view illustrating the magnetic sensor taken along Line B-B shown in Fig. 7, viewed from the arrow direction.
Fig. 9 is a partially enlarged top plan view illustrating the magnetic sensor with a structure different from that shown in Fig. 5A, Fig. 5B, Fig. 6, and Fig. 7 according to the embodiment of the application.
Fig. 10 is a diagram illustrating a circuit configuration of the magnetic sensor shown in Fig. 3.
Fig. 11 is a partially sectional view illustrating the magnetic sensor with a type different from that shown in Fig. 4.
Fig. 12 is a graph illustrating a hysteresis characteristic of a fixed resistance element which prepares the magnetic sensor shown in Fig. 11.
Fig. 13 is a graph illustrating a relationship of a coupling magnetic field between a film thickness of a non-magnetic layer, a fixed layer of a magnetoresistance effect element, and a free layer.
Fig. 14 is a graph illustrating a relationship between an element width of the magnetoresistance effect element and a coercive force Hc of the free layer.
Fig. 15 is a graph illustrating the hysteresis characteristic of the magnetoresistance effect element shown in Fig. 4 and Fig. 11.
Fig. 16 is a process view illustrating a method of manufacturing the magnetic sensor according to the application of the application (partially top plan view).
Fig. 17 is a process diagram illustrating processes performed after the processes illustrated in Fig. 16 (partially top plan view).
Fig. 18 is a process diagram illustrating processes performed after the processes illustrated in Fig. 17 (partially top plan view).
Fig. 19 is a process diagram illustrating processes performed after the processes illustrated in Fig. 18 (partially top plan view).

### DESCRIPTION OF THE PREFERRED EMBODIMENTS

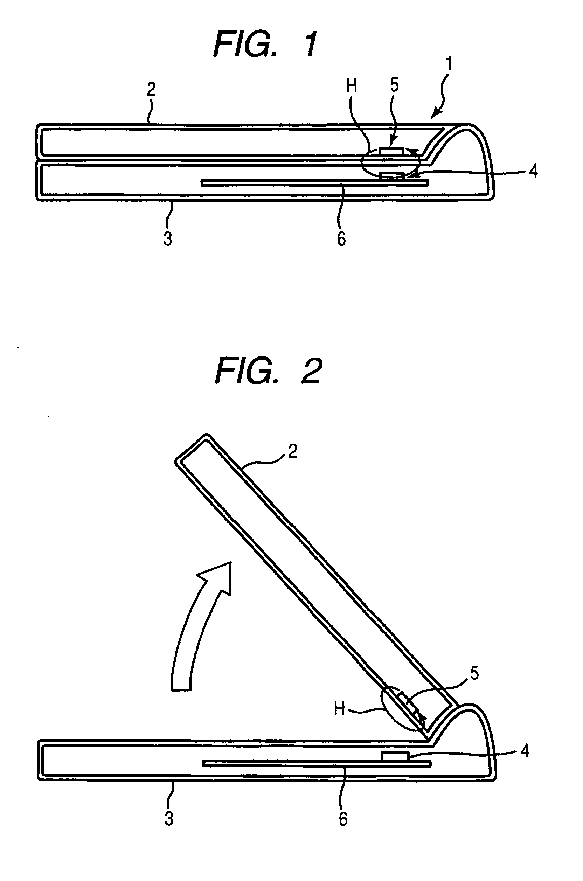

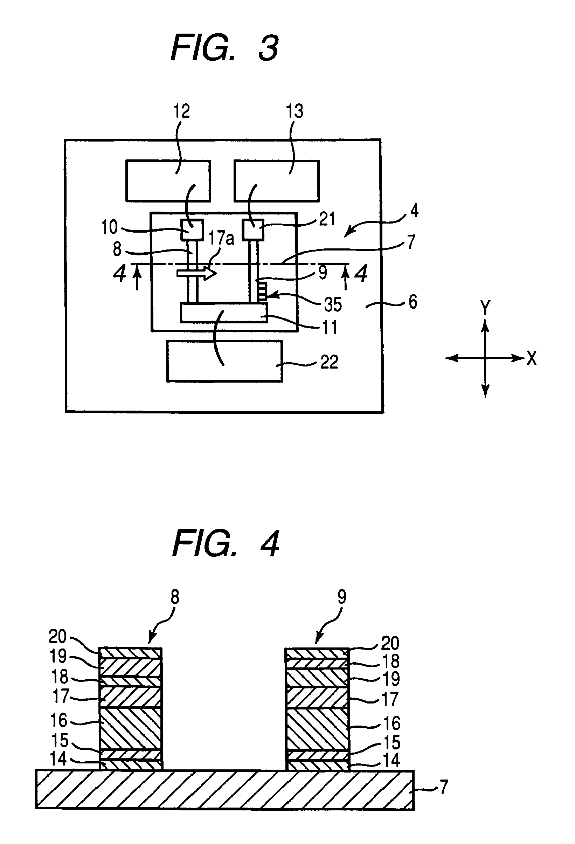

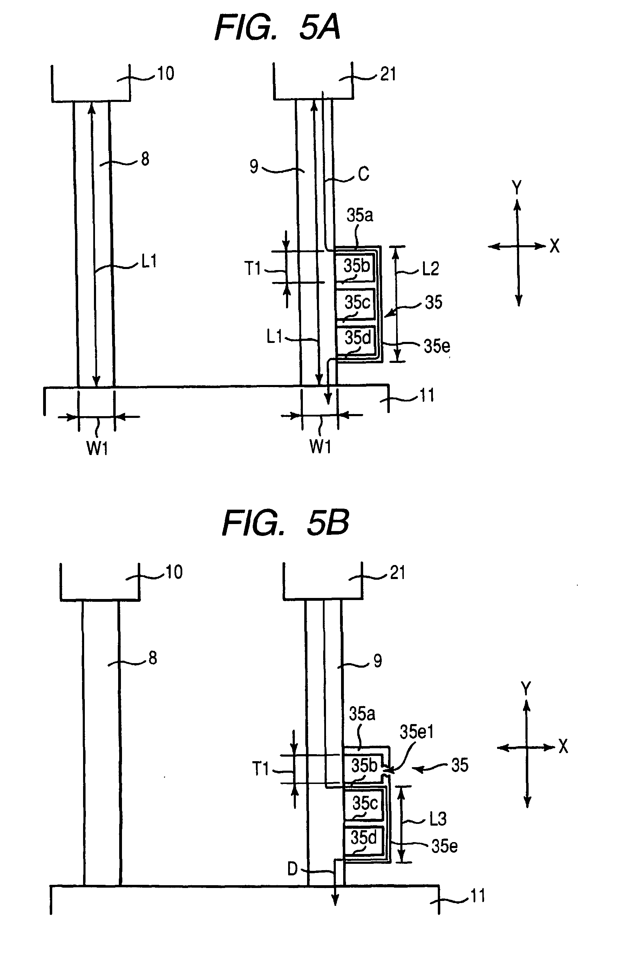

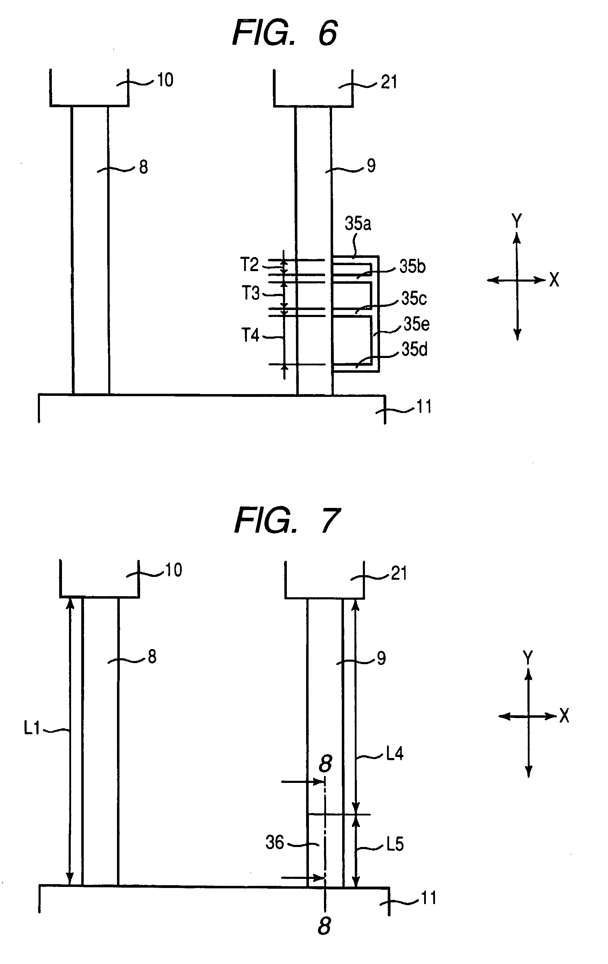

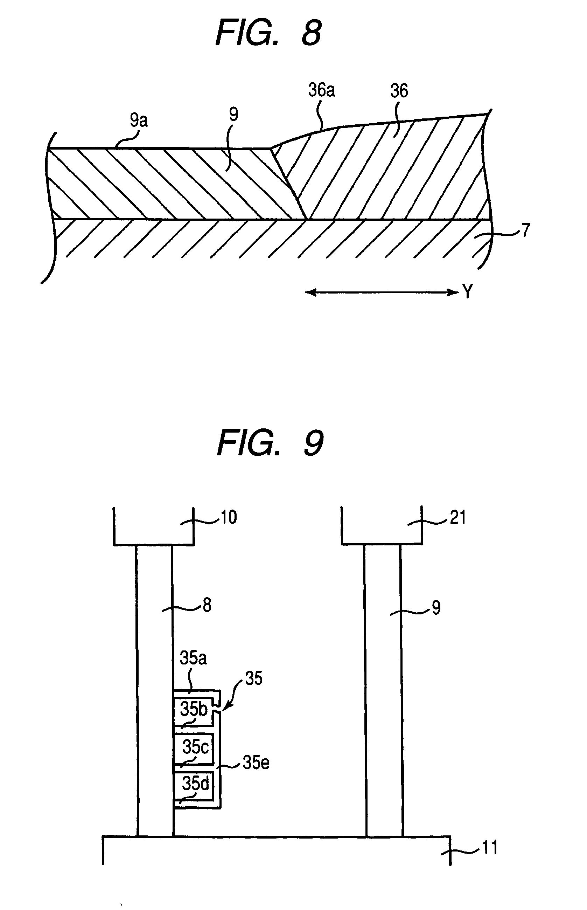

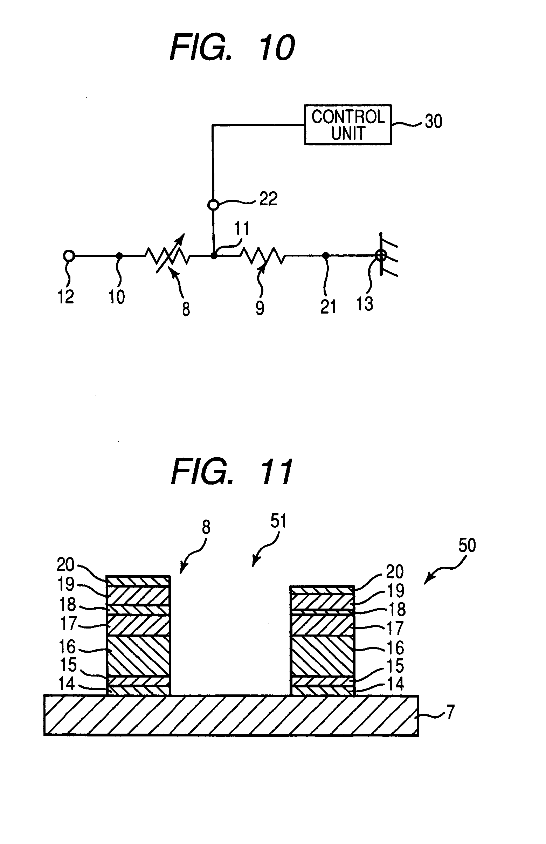

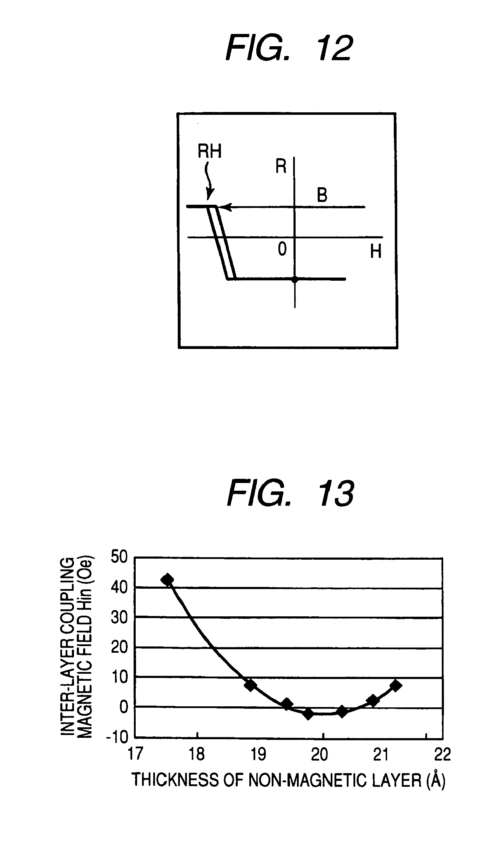

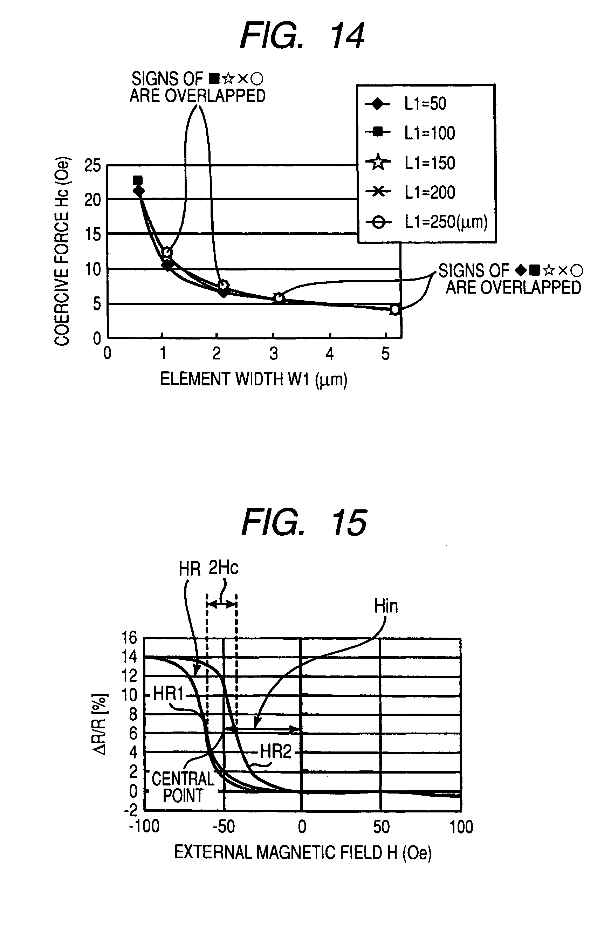

Fig. 1 and Fig. 2 are partially schematic diagrams illustrating a foldable cellular phone with a built-in magnetic sensor according to an embodiment. Fig. 3 is a partially top plan view illustrating a magnetic sensor according to the embodiment of the application. Fig. 4 is a partial and cross sectional view illustrating the magnetic sensor taken along a line A-A of Fig. 3, viewed from an arrow direction in Fig.3. Figs. 5A and 5B are a partially enlarged top plan view illustrating the magnetic sensor. Fig. 6 is a partially enlarged top plan view illustrating the magnetic sensor with a structure different from that shown in Fig. 5 according to the embodiment of the application. Fig. 7 is a partially enlarged top plan view illustrating the magnetic sensor with a structure different from that shown in Fig. 5A, Fig. 5B, and Fig. 6 according to the embodiment of the application. Fig. 8 is a partially enlarged cross-sectional view illustrating the magnetic sensor taken along Line B-B as shown in Fig. 7, viewed from the arrow direction. Fig. 9 is a partially enlarged top plan view illustrating the magnetic sensor with a structure different from that shown in Fig. 5A, Fig. 5B, Fig. 6, and Fig. 7 according to the embodiment of the application. Fig. 10 is a diagram illustrating a circuit configuration of the magnetic sensor shown in Fig. 3. Fig. 11 is a partially sectional view illustrating the magnetic sensor with a type different from that shown in Fig. 4. Fig. 12 is a graph illustrating a hysteresis characteristic of a fixed resistance element which prepares the magnetic sensor shown in Fig. 11. Fig. 13 is a graph illustrating a relationship of a coupling magnetic field between a film thickness of a non-magnetic layer, a fixed layer of a magnetoresistance effect element, and a free layer. Fig. 14 is a graph illustrating a relationship between an element width of the magnetoresistance effect element and a coercive force Hc of the free layer. Fig. 15 is a graph illustrating the hysteresis characteristic of the magnetoresistance effect element shown in Fig. 4 and Fig. 11.

As shown in Fig. 1, a foldable cellular phone 1 has a first member 2 and a second member 3. The first member 2 is formed in a screen display and the second member 3 is formed in an operation body. A liquid crystal display, a receiver, and the like are provided on a surface of the first member 2 opposite to the second member 3. Buttons, a microphone, and the like are provided on a surface of the second member 3 opposite to the first member 2. As shown in Fig. 1, the foldable cellular phone 1 is in a closed state. As shown in Fig. 1, a magnet 5 is built in the first member 2, and a magnetic sensor 4 is built in the second member 3. The magnet 5 and the magnetic sensor 4 are disposed to face each other (opposed in a direction perpendicular to the formation surface of the magnet 5 and the magnetic sensor 4) in the closing state as shown in Fig. 1.

As shown in Fig. 1, an external magnetic field H exerting from the magnet 5 is applied to the magnetic sensor 4, and then the external magnetic field H is detected by the magnetic sensor 4. In this manner, the closed state of the foldable cellular phone 1 is detected.

Meanwhile, when the foldable cellular phone 1 is opened as shown in Fig. 2, the magnitude of the exterior magnetic field H applied to the magnetic sensor 4 gradually decreases as the first member 2 is separated far away from the second member 3, and finally becomes zero. When the magnitude of the exterior magnetic field H applied to the magnetic sensor 4 becomes zero or decreases to a predetermined magnitude or less, the open state of the foldable cellular phone 1 is detected. Then, a controller mounted in the foldable cellular phone 1 controls a back light on a back side of the liquid crystal display or the operation button, for example, to emit light.

As shown in Fig. 3, the magnetic sensor 4 according to the embodiment is mounted on a circuit board 6 built in the second member 3. One magnetoresistance element 8 and one fixed resistor 9 are provided on an element base 7 of the magnetic sensor 4. As shown in Fig. 3, terminal sections 10 and 11 are provided on both sides of the magnetoresistance element 8 in a length direction thereof. For example, the terminal section 10 is electrically connected to an input terminal (power supply Vcc) 12 provided on the substrate 6 by a wire-bonding, a die-bonding, and the like (refer to Fig. 10). The terminal section 11 serves as a common terminal shared by the fixed resistor 9 and is electrically connected to an output terminal 22 on the substrate 6 by the wire-bonding, the die-bonding, and the like (refer to Fig. 10).

As shown in Fig. 3, the above-described terminal section 11 and a terminal section 21 are provided on both sides of the fixed resistor 9 in the length direction. The terminal section 21 is electrically connected to an earth terminal 13 on the circuit board 6 by the wire-bonding, the die-bonding, and the like (refer to Fig. 10).

Since the magnetoresistance element 8 and the fixed resistor 9 are mounted on the element base 7, the terminal section 11 provided on edges of magnetoresistance element 8 and the fixed resistor 9 can serves as a common terminal. Accordingly, the bonding number can decrease, thereby lowering the manufacturing cost. In addition, the magnetic sensor 4 can decrease in size.

As shown in Fig. 4, the magnetoresistance element 8 is sequentially laminated on an underlying layer 14, a seed layer 5, an anti-ferromagnetic layer 16, a fixed layer 17, a non-magnetic layer 18, a free layer 19, and a protection layer 20, in this order from a bottom. The underlying layer 14, for example, is formed of a non-magnetic material such as at least one atom or more of Ta, Hf, Nb, Zr, Ti, Mo, or W. The seed layer 15 is formed of NiFeCr, Cr, or the like. The anti-ferromagnetic layer 16 is formed of an anti-ferromagnetic material containing an atom a (where a is at least one atom of Pt, Pd, Ir, Rh, Ru, or Os) and Mn or that containing atoms a, a' (where a' is at least one atom or more of Ne, Ar, Kr, Xe, Be, B, C, N, Mg, Al, Si, P, Ti, V, Cr, Fe, Co, Ni, Cu, Zn, Ga, Ge, Zr, Nb, Mo, Ag, Cd, Sn, Hf, Ta, W, Re, Au, Pb, or a rare earth atom) and Mn. For example, the anti-ferromagnetic layer 16 is formed of IrMn or PtMn. The fixed layer 17 and the free layer 19 are formed of magnetic material such as CoFe alloy, NiFe alloy, CoFeNi alloy. In addition, the non-magnetic layer 18 is formed of Cu, and the like. In addition, the protection layer 20 is formed of Ta and the like. The fixed magnetic layer 17 or the free magnetic layers 19 may have a laminated ferri structure (a structure in which a magnetic layer / a non-magnetic layer / a magnetic layer are laminated and a structure in which a non-magnetic layer is interposed between two magnetic layers of which magnetization directions are anti-parallel each other). The fixed magnetic layer 17 or the free magnetic layers 19 may be a laminated structure formed of a plurality of magnetic layers with different materials.

Since the anti-ferromagnetic layer 16 and the fixed layer 17 in the magnetoresistance element 8 are formed in contact, an exchange coupling magnetic field (Hex) occurs in an interface between the anti-ferromagnetic layer 16 and the fixed layer 17 by performing a heat treatment process in a magnetic field, and thus a magnetization direction of the fixed layer 17 is fixed in one direction. A magnetization direction 17a of the fixed layer 17 is shown as an arrow direction in Fig. 3. The magnetization direction 17a is perpendicular to the length direction (a width direction of the element). On the other hand, the free layer 19 is opposed to the fixed layer 17 and the non-magnetic layer 18, and the magnetization direction of the free layer 19 is not fixed in one direction. That is, the magnetization of the free layer 19 changes in accordance with the external magnetic field.

As shown in Fig. 4, the fixed resistor 9 is sequentially formed of the underlying layer 14, the seed layer 15, the anti-ferromagnetic layer 16, the first magnetic layer 17, the second magnetic layer 19, becomes equal and the element length L1 and the element width W1 becomes equal, a resistance value (at a state with non-magnetic field) and the temperature coefficient of the magnetoresistance element 8 and the fixed resistance element 9 completely accord. However, since the order of the magnetoresistance element 8 and the fixed resistance element 9 is formed respectively, a difference of the thickness, and so on occurs at the time of forming a film. Accordingly, it is difficult to accord with a resistance value of the magnetoresistance element 8 and the fixed resistance element 9.

According to the embodiment, as shown in Fig. 5, a conductor 35 in which a resistance value (resistance rate) is substantially lower than the fixed resistance element 9 such as Cu is connected in a side of the fixed resistance element 9 and a resistance value between the terminal portion 11 and the terminal portion 21 varies. In addition, the resistance value (resistance rate) of the fixed resistance element 9 is higher than that of the magnetoresistance element 8. The resistance value of the magnetoresistance element 8 and the fixed resistance element 9 is in the range of 500 Ω to 10000 Ω (those have about 20 ohms-per-square) and the resistance value of the conductor 35 is in the range of 50 mΩ to 100 mΩ (resistance rate is in the range of 1.7 µΩ·cm to 304 Ω·cm). The conductor 35 may be formed such as the non-magnetic layer 18, and the protection layer 20 in this order from a bottom surface. The first magnetic layer 17 and the second magnetic layer 19 in the fixed resistor 9 correspond to the fixed layer 17 and the free layer 19 in the magnetoresistance element 8, respectively. That is, an order of laminating the non-magnetic layer 18 and the free layer 19 in the magnetoresistance element 8 is changed each other in the fixed resistor 9. Materials of each common layer in the magnetoresistance 8 and the fixed resistor 9 are equal.

According to the embodiment shown in Fig. 4, the first magnetic layer 17 and the second layer 19 in the fixed resistor 9 are formed to contact. The anti-ferromagnetic layer 16 is formed in contact with the first magnetic layer 17 or the second magnetic layer 19. The anti-ferromagnetic layer 16, the first magnetic layer 17, and the second magnetic layer 19 are sequentially laminated in Fig. 4. Accordingly, when the heat treatment in a magnetic field is performed, the exchange coupling magnetic field (Hex) is imparted in an interface between the anti-ferromagnetic layer 16 and the first magnetic layer 17 to fix the magnetization of the first magnetic layer 17 in one direction. However, the magnetization of the second magnetic layer 19 formed in contact with the first magnetic layer 17 is also fixed in the same direction as the magnetization direction of the first magnetic layer 17 due to an anti-ferromagnetic coupling between the second magnetic layer 19 and the first magnetic layer 17.

According to the embodiment shown in Fig. 4, since a different lamination order in the fixed resistance element 9 but with the same constituent layers as that of the magnetoresistance element 8, it is possible to suppress deviation of the temperature coefficient (TCR) of the fixed resistance element 9.

As shown in Fig. 3, the magnetoresistance element 8 and the fixed resistor 9 are all formed in an elongated linear shape in Y direction in the figure. As shown in Fig. 5A, a longitudinal of the magnetoresistance element 8 and the fixed resistance element 9 is L1 and an element width of the magnetoresistance element 8 and the fixed resistance element 9 is W1. As shown in Figs. 3 and 5, the longitudinal L1 is substantially longer than the element width W1. The magnetoresistance element 8 and the fixed resistance element 9 may not be formed in a linear shape, for example, the meandering or sepentine shape and the like which is like a curve shape. The element length L1 is set to a length of a center line of the element width W1 at the time of relating.

The magnetoresistance element 8 and the fixed resistance element 9 have the same constituent layers. Accordingly, when the thickness of a common layer Au, Ag, Cr, Ta, W, and Al other than Cu.

A resistance value R1 in which the fixed resistance element 9 is connected between the terminal portions 11, 21 and a resistance value R2 in which the magnetoresistance element 8 is connected between the terminal portions 10, 11 will be described hereinafter.

Fig. 5A illustrates a state (before cutting the conductor) where the conductor is connected to the fixed resistance element 9. Fig. 5B illustrates a state where a part of the conductor is cut so as to adjust the resistance.

As shown in Fig. 5A, the conductor 35 in a length element direction (Y direction in the figure) includes four divisional path pieces 35a to 35d connected to a side of the fixed resistance element 9 by emptying a gap of the width T1 and a common path piece 35e connected between the divisional path pieces 35a to 35d.

As shown in Fig. 5A, since the conductor 35 is connected the side of fixed resistance element 9, the conductor 35 is connected to the fixed resistance element 9 in parallel. A current flowing between the terminal portion 11 and the terminal portion 21 by the connection of the conductor 35 flows from the fixed resistance element 9 to the conductor 35 having a low resistance value. An arrow C shows a current route. As shown in Fig. 5A, the current flows inside the conductor 35 through a path in which a length of a current path L2 is the most longest in a length direction of the element (Y direction in the figure), that is, the path of the divisional path piece 35a, the common path piece 35e, and the divisional path piece 35d. In fig. 5A, the length of the current path L2 shows a length from a center of the division path piece 35a to a center of the division path piece 35d in the length direction (Y direction in the figure).

As shown in Fig. 5A, the resistance value R1 may decrease by the connection of the conductor 35 rather than when the conductor 35 is not connected, adjusting resistance may be easily performed with high precision. In addition, since the fixed resistance element 9 may not be trimmed in the related art, the fixed resistance element 9 may not be damaged.

As shown in Fig. 5A, since an adjustment of the resistance is not necessary when the conductor 35 is connected to the fixed resistance element 9 and the resistance value R1 departs from the resistance value R2 within an allowable range. In the embodiment, in view of Fig. 5A, the conductor 35 in which the length of the current path L2 is controlled so as to easily adjust the resistance with high precision is connected so that the resistance value R1 is lower than the resistance value R2. In Fig. 5A, since the length of the current path L2 which flows the conductor 35 has the most longest in the length direction of the element (Y direction in the figure), the resistance value R1 is in a lowest state. However, when a part of the divisional path pieces 35a, 35d departing from the length direction of the element (Y direction in the figure) or the common path piece 35e is cut, the length of the current path in the length direction of the element of the conductor 35 is shortened from L2 to L3. In Fig. 5B, a part of the common path piece 35e1 of the common path piece 35e is cut by a laser and the like. Accordingly, in Fig. 5B, the current path which flows inside the conductor 35 is formed by the divisional path piece 35b, the common path piece 35e, and the divisional path piece 35d. Accordingly, since the length of the current path L3 in the length direction (Y direction in the figure) is shorter than that of Fig. 5A and the length of the current path flowing to the fixed resistance element 9 is elongated, the resistance value R1 in Fig. 5B rises more than that of Fig. 5A.

In the state shown in Fig. 5A, the resistance values R1, R2 are measured and accordingly an increased amount of resistance ΔR3 is set. In addition, the increased amount of resistance ΔR3 which is necessary to the resistance value R1. In addition, a cutting position of the conductor 35 is determined in accordance with the increased amount of resistance ΔR3. For example, as shown in Fig. 5B, when an increased amount of resistance ΔR2 from Fig. 5A is smaller than the increased amount of resistance ΔR3 and the resistance value R1 departs from the resistance value R2, for example, the divisional path piece 35b is cut. Accordingly, the current path flowing to the conductor 35 is formed by the divisional path piece 35c, the common path piece 35e, and the divisional path piece 35d. Accordingly, a length of the current path in the length direction of the element is shortened than the state of Fig. 5 and the resistance value R1 increases more than that of Fig. 5B. In addition, when the resistance value R1 and the resistance value R2 departs from the allowable range, the operation ends at the time of cutting to the conductor 35.

Accordingly, the adjustment of the resistance may be performed with high precision by adjusting the resistance value R1.

In Figs. 5A and 5B, gaps between the divisional path pieces 35a to 35d are the same as T1. As shown in Fig. 6, it is possible that the gap between the divisional path pieces 35a to 35d may be adjusted differently.

As shown in Fig. 6, a gap between the divisional path piece 35a and the divisional path piece 35b is formed of T2, a gap between the divisional path piece 35b and the divisional path piece 35c is formed of T3, and a gap between the divisional path piece 35c and the divisional path piece 35d is formed of T4. The gap T4 is larger than that of the gap T3 and the gap T3 is larger than that of the T2. In the conductor 35 of Fig. 5A, since the divisional path pieces 35a to 35d are formed with a constant gap, the increased amount of resistance is almost constant whenever cutting any part of the conductor 35 other than a part in which the length of the current path does not vary. For example, even when cutting the divisional path piece 35a and the divisional path piece 35d from Fig. 5A, the length of the current path is almost constant. Accordingly, the increased amount of resistance is almost constant.

On the other hand, in Fig. 6, since the divisional path pieces 35a to 35d are not formed with a constant gap, the increased amount of resistance may be adjusted differently by the cutting position of the conductor 35. For example, as shown in Fig. 6, at the time of cutting the divisional path piece 35a, the length of the current path in the length direction of the element (Y direction in the figure) is shortened by T2. On the other hand, when cutting the divisional path piece 35d, the length of the current path is shortened by T4. In addition, when cutting the common path piece 35d between the divisional path piece 35b and the divisional path piece 35c, the length of the current path in the length direction of the element is shortened by T3. Accordingly, since the length of the current path has a different value in accordance with the cutting position in the length direction of the element and the increased amount of resistance varies, the adjustment of resistance may be easily performed with high precision by deciding the cutting position in accordance with the increased amount of resistance ΔR3.

In Figs. 7 to 8, a part of the resistance element 9 which has a high resistance value is removed by the trimming such as an ion milling process and a conductor 36 such as Cu which has a lower resistance value that the fixed resistance element 9 in the removed part is buried. The conductor 36 is connected to the fixed resistance element 9 in series.

As shown in Fig. 7, a length L1 is formed in the length direction of the element (Y direction in the figure) of the magnetoresistance element 8. In the first place, although the fixed resistance element 9 is formed of the length L1 in the length direction of the element according with the magnetoresistance element 8, the resistance value of the fixed resistance element 9 is higher than that of the magnetoresistance element 8. Accordingly, the resistance value R1 is higher than the resistance value R2. Accordingly, according to the embodiment shown in Fig. 7, a part of the fixed resistance element 9 is removed, a length L4 in the length direction of the element (Y direction in the figure) is shortened, a length L5 is formed in the removed part in the length direction of the element, and small conductor 36 is filled with the resistance value which is substantially smaller than that of the fixed resistance element 9. Accordingly, the resistance value R1 may be decreased, the adjustment of the resistance may be easily performed with high precision. By connecting the conductor 36 to the fixed resistance element 9, the resistance value R1 becomes a value which is made by adding the resistance value of the fixed resistance element 9 and the resistance value of the conductor 36. The conductor 36 has a very small resistance value to the fixed resistance element 9 and the resistance value R1 may be decided on the resistance value of the fixed resistance element 9.

The conductor 36, for example, by providing a lift-off resist layer on an upper surface 9a which is not removed of the fixed resistance element 9, the fixed resistance element 9 which is not covered on the lift-off resist layer is removed, and the lift-off resist layer is removed after burying the conductor 36 to the removed position, for example, by a sputter method, and the like.

As shown in Fig. 8, although an upper surface 36a of the conductor 36 protrudes more in an upper direction than the upper surface 9a of the fixed resistance element 9, the upper surface 36a is not particularly limited to the above-mentioned shape.

According to the embodiment shown in Figs. 5 to 8, although the conductor 35 and the conductor 36 are connected to the fixed resistance element 9, the conductor 35 and the conductor 36 may be connected to the magnetoresistance element 8.

As shown in Fig. 9, a side of the magnetoresistance element 8 is connected to the conductor 35 which is described in Fig. 5B. According to the embodiment of Fig. 9, since the magnetoresistance element 8 has a lower resistance value than the fixed resistance element 9, the conductor 35 having a lower resistance value than the magnetoresistance element 8 so as to lower the resistance value R2 is connected to the magnetoresistance element 8 and the resistance value R2 is adjusted.

In addition, a part of the magnetoresistance element 8 may be cut according with Figs. 7 and 8 and the conductor 36 having a lower resistance value (resistance rate) than the magnetoresistance element 8 may be filled in the cut part. However, in this case, characteristics of the magnetoresistance element 8 may be changed by the trimming to the magnetoresistance element 8. However, when a part of the magnetoresistance element 8 is removed, a coercive force Hc of a free layer 19 or an interlayer-coupling magnetic field Hin does not vary. Accordingly, the hysteresis characteristic of the magnetoresistance element 8 may not vary.

For example, the conductor 35 shown in Fig. 5A may be connected to both sides of the magnetoresistance element 8 and the fixed resistance element 9, a resistance value between the both sides of the terminal portions is measured, and a part of the conductor 35 which is connected to the magnetoresistance element 8 or the fixed resistance element 9 may be cut in accordance with the measured result.

In the embodiment as described above, the resistance value R1 or the resistance value R2 may easily adjusted with high precision. As shown in Figs. 3 and 10, for example, when 5 V is applied from an input terminal (power supply Vcc), an output value (central potential) from the magnetic sensor 4 nearly becomes 2.5 V at a state with non-magnetic field. In the embodiment, however, amount of deviation of the central potential from the 2.5 V may be small or more preferably the amount of the deviation of the central potential may become zero.

In the embodiment, as shown in Fig. 4, since a constitution layer of the magnetoresistance element 8 and the fixed resistance element 9 are the same, the diffefence of the temperature coefficient (TCR) of the magnetoresistance element 8 and the fixed resistance element 9, and the deviation of the central potential may be decreased in accordance with the variation in temperature.

In addition, according to the embodiment, since the constitution layer of the magnetoresistance element 8 is the same as the fixed resistance element 9, a resistance value of the magnetoresistance element 8 and a resistance value of the fixed resistance element 9 are not greatly different, that is, a final fine-tuning is performed. Accordingly, the time of the adjustment of the resistance may be shorter than the time when the resistance value is greatly different. In the embodiment, a structure of the fixed resistance element 9 is not limited to a structure of Fig. 4.

In the magnetic sensor 51 shown in Fig. 11, two magnetoresistance elements 8, 50 are disposed on the element base 7. The interlayer-coupling magnetic field Hin of the one magnetoresistance element 50 grows larger than the interlayer-coupling magnetic field of the other magnetoresistance element 8. Although the magnetoresistance element 8 and the magnetoresistance element 50 have the same constitution layer and the lamination order, a film thickness of the non-magnetic layer 18 of the magnetoresistance element 50 is formed thinner in film thickness of the non-magnetic layer 18 of the magnetoresistance element 8.

Herein, an experimental result of Fig. 13 will be described. The film thickness of the magnetoresistance element used in the experiment is sequentially formed of a seed layer: NiFeCr/anti-ferromagnetic layer: IrMn/fixed layer: [Fe_{30at%}Co_{70at%}/Ru/CoFe]/non-magnetic layer: Cu/free layer:[Cofe/Nife]/protection layer: Ta. The Cofe of the free layer has 10 Å and the Nife has 30 Å. In addition, after forming the magnetoresistance element, heat treatment in the magnetic field may be performed, and the magnetization direction of the fixed layer may be fixed in the same direction.

In the experiment, the interlayer-coupling magnetic field which acts between the film thickness of the non-magnetic layer 18 formed of Cu, the fixed layer 17, and the free layer 19 will be examined. The experiment result is Fig. 13.

As shown in Fig. 13, when the film thickness of the non-magnetic layer 18 varies, the interlayer-coupling magnetic field Hin varies.

In the embodiment shown in Fig. 11, a thickness of the non-magnetic layer 18 of the magnetoresistance element 50 is thinner than a thickness of the non-magnetic layer 18 of the magnetoresistance element 8. As shown in Fig. 13, since the interlayer-coupling magnetic field Hin increases by lessening the thickness of the non-magnetic layer 18, the interlayer-coupling magnetic field Hin of the magnetoresistance element 50 increases more than the interlayer-coupling magnetic field Hin of the magnetoresistance element 8. As a result, a hysteresis characteristic loop RH of the magnetoresistance element 50 may be greatly shifted to the side. In addition, when a range B is the external magnetic field H as shown in Fig. 12, the magnetoresistance element 50 does not exhibit the magnetoresistance effect and the resistance value does not vary, so that the external magnetic field H does not vary. Accordingly, the magnetoresistance element 50 serves as the fixed resistance. In addition, the magnetoresistance element 8 exhibits the magnetoresistance effect in the range of B of the external magnetic field H and serves as a variable resistance.

In the embodiment of Fig. 11, so as to vary the film thickness of the non-magnetic layer 18 of the magnetoresistance elements 8, 50, the non-uniform of a temperature coefficient (TCR) of the magnetoresistance element 8 and the magnetoresistance element 50 grows larger than a shape of Fig. 4. However, the non-uniform of the temperature coefficient (TCR) may be lowered, compared with the case of the known magnetic sensor in which the magnetoresistance element 8 and the fixed resistance element is formed of different material. Accordingly, it is possible to reduce the non-uniform of the central potential.

In addition, as shown in Figs. 7 to 8, although a part of the magnetoresistance elements 8, 50 is removed and element length of the magnetoresistance elements 8, 50 is shortened, the coercive force Hc of the free layer 19 forming the magnetoresistance elements 8, 50 does not vary. In the magnetic sensor 4, it is necessary that the coercive force Hc has some size so as to prevent from malfunctioning such as chattering by variation of the external magnetic field H. Fig. 14 is an experimental result showing a relationship of a width of the magnetoresistance element 8 and the coercive force Hc. A film constitution of the magnetoresistance element 8, which is used in the experiment, is the same as that of Fig. 13. In the experiment, a relation of the width W1 (refer to Fig. 5A) and the coercive force Hc of the free layer 19 was examined at the time of varying the element length L1 (refer to Fig. 5A) of the magnetoresistance element 8 in the range of 50 to 250 µm.

As shown in Fig. 14, the coercive force Hc does not practically rely upon the element length L1 and relies upon the width W1.

Accordingly, when a part of the magnetoresistance elements 8, 50 is removed as shown in Figs. 7 and 8 and the element length is shortened, the coercive force Hc of the magnetoresistance elements 8, 50 may be regularly maintained.

Also, the coercive force Hc is a factor which determines the hysteresis characteristic with the interlayer-coupling magnetic field Hin. Fig. 15 is the hysteresis characteristic of the magnetoresistance element 8 which is mounted on the magnetic sensor 4 used for detection opening and closing states.

A transverse axis of Fig. 15 is magnitude of the external magnetic field H and an longitudinal axis is a size of a resistance variation rate (ΔR/R) of the magnetoresistance element 8. A hysteresis loop HR denotes a part surrounded by a curve HR 1 and HR 2. The interlayer coupling magnetic filed Hin is represented as magnetic field magnitude from a line of the external magnetic field H=0 (Oe) to a central point of the hysteresis loop HR. A enlarged width in a width direction in a mean value between a maximum value of the resistance rate (ΔR/R) and a minimum value is represented as 2×coercive force Hc (shown in 2 Hc in graph) and a center value of the enlarged width is "a central point" of the hysteresis. In addition, when one direction of the external magnetic field H is a positive direction, an external magnetic filed H of a negative value is represented as an inverse magnetic field. In the hysteresis characteristic shown in Fig. 15, since the interlayer coupling magnetic field Hin increases more than the coercive force Hc, the hysteresis loop HR is not over line H=0 Oe and the hysteresis loop HR is shifted to a left side of the line of the external magnetic field H=0 Oe in Fig. 15.

In the detection opening and closing states of the foldable cellular phone shown in Fig. 1 and Fig. 2, strong and weak of the external magnetic field H from the magnet 5 is detected to the magnetic sensor 4. Accordingly, as shown in Fig. 15, when the hysteresis loop HR is shifted to a region in which the external magnetic field H is the positive or one region in which the magnetic field H is negative, the magnetoresistance element 8 detects efficiently the strong and weak of the external magnetic field H.

Hereinafter, an output principle of a switching signal will be explained. For example, a resistance variation rate of 6% is set at a critical value. When the resistance variation rate of 6% is obtained, a voltage may be obtained. Accordingly, the voltage is saved to a control unit 30 as the critical voltage.

When the external magnetic filed H exerts on the magnetic sensor 4 and the value (absolute value) is increased, the resistance variation rate (ΔR/R) of the magnetoresistance element 8 is gradually increased along the hysteresis loop HR as shown in Fig. 15. At this time, in the control unit 30, for example, the voltage value outputted from the magnetic sensor 4 at regular time and the critical value are compared, and switched signal is outputt, in which the foldable cellular phone 1 is closed and the switch becomes off (no signal is usually outputted when the switch becomes off), when the control unit 30 detects that the resistance variation rate (ΔR/R) exeeds 6% , for example, the voltage value outputt from the magnetic sensor 4 becomes less than the critical voltage. On the other hand, when the control unit 30 detects that the magnitude (absolute value) of the external magnetic field H exerting on the magnetic sensor 4 gradually decreases, for example, the resistance variation rate (ΔR/R) of the magnetoresistance element 8 is 6% or less, and the output from the magnetic sensor 4 increases more than the critical value, the switched signal is outputt, in which the foldable cellular phone 1 is opened and the switch becomes on. Accordingly, the control unit 30 includes the output value which is varied corresponding to the intensity variation of the magnetic field H, a comparison unit which compares the set critical value, thereby providing a function outputting the switched signal on the basis of the compared result.

As shown in Fig. 15, the resistance variation rate (ΔR/R) having 6% is the time when the external magnetic field H have -60 Oe (about 4740 A/m) and -40 Oe (about -3160 A/m). In other words, the external magnetic field H has a coercive force Hc which is about 10 Oe and as shown in Fig. 15, the curve HR 1 of the hysteresis loop HR and curve HR 2 are open in a transverse axis. Accordingly, since it is difficult to exhibit fluctuation of the switched signal generated from some external magnetic field H, it is possible to prevent from generating the malfunctioning such as the chattering as above-mentioned.

When the magnetic sensor 4 detects polarity change of the external magnetic field H, it is desirable that the magnetoresistance element 8 mounted onto the magnetic sensor 4 has the hysteresis characteristic in which the coercive force Hc is larger than the interlayer coupling magnetic field Hin.

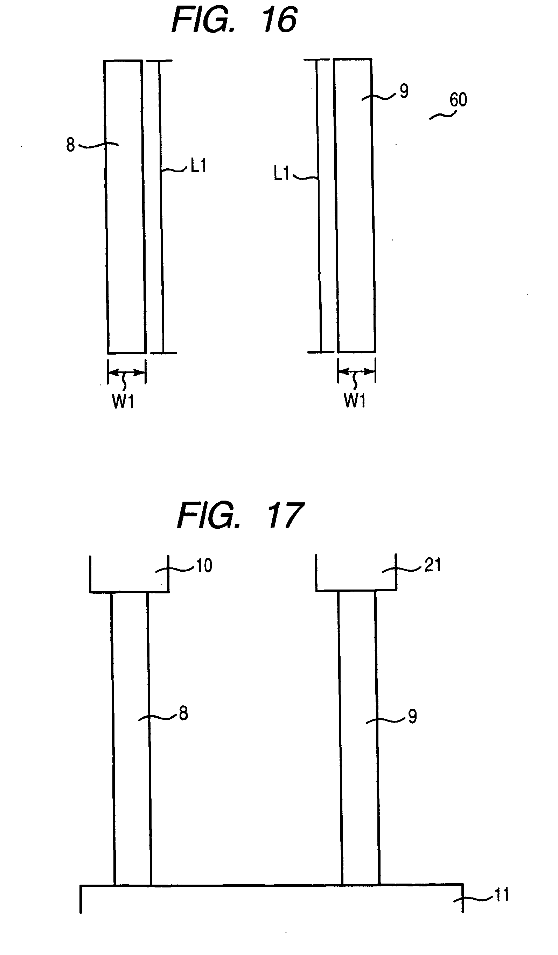

Next, a method of manufacturing the magnetic sensor 4 will be described according to the embodiment. In a process shown in Fig. 16, the magnetoresistance element 8 is trimmed after the magnetoresistance element 8 may be sequentially formed of an underlying layer 14, a seed layer 15, an anti-ferromagnetic layer 16, a fixed layer 17, a non-magnetic layer 18, a free layer 19, and a protection layer 20 in this order from a bottom surface on a substrate 60. At this time, a plane shape of the magnetoresistance element 8 is larger than that of the magnetoresistance element 8 shown in Fig. 16. Next, the fixed resistance element 9 is sequentially formed of the underlying layer 14, the seed layer 15, the anti-ferromagnetic layer 16, the first magnetic layer 17, the second magnetic layer 19, the non-magnetic layer 18, and the protection layer 20 in a order from the bottom in a state where a resist layer (not shown) is protected on the magnetoresistance element 8. In addition, after removing the resist layer, the magnetoresistance element 8 and the fixed resistance element 9 are simultaneously trimmed so that the element length is L1 and the element width is W1 as shown in Fig. 16.

In addition, a plurality of sets, each of which includes the magnetoresistance element 8 and the fixed element 9, are formed on the substrate 60.

In a process shown in Fig. 17, the terminal portion 10 is formed in a position in contact with an end portion of the magnetoresistance element 8, the terminal portion 21 is formed in a position in contact with an end portion of the fixed resistance element 9, and the common terminal portion 11 is formed in a position in contact with the other end portion of the magnetoresistance element 8 and the fixed resistance element 9.

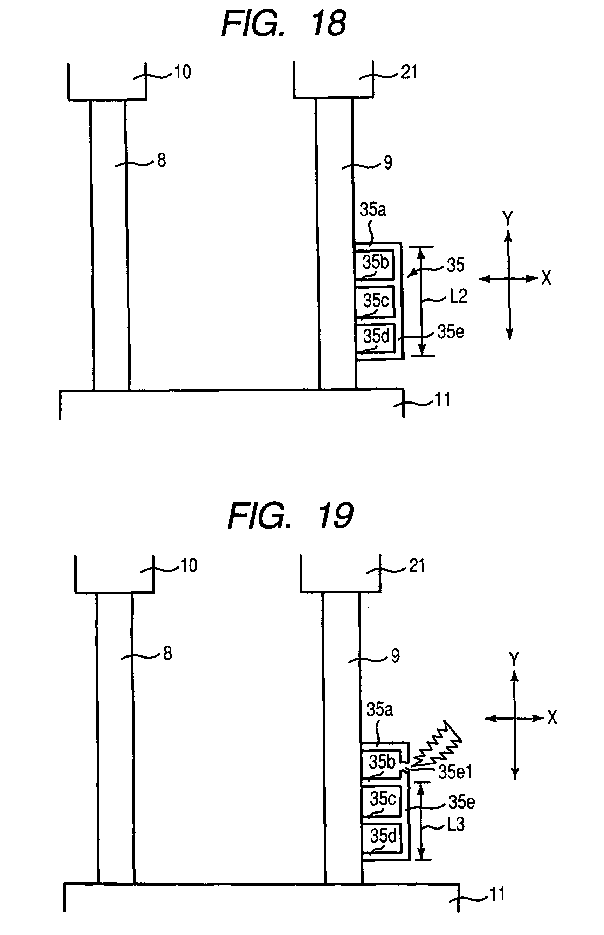

Next, in a process shown in Fig. 18, firstly, the resistance value R2 between the terminal portion 10 and the terminal portion 11 and the resistance value R1 between the terminal portion 11 and the terminal portion 21. As above-mentioned, since the magnetoresistance element 8 and the fixed resistance element 9 are differently formed by different process each other, it is difficult to correspond with the resistance value of the magnetoresistance element 8 and the fixed resistance element 9. Accordingly, a difference between the resistance value R1 and the resistance value R2 has a tendency to come about.

When the resistance value R1 is larger than.the resistance value R2, the conductor 35 which is smaller than the resistance value of the fixed resistance element 9 is connected on a side of the fixed resistance element 9 so as to lower the resistance value R1. The conductor 35 is formed of Cu which has substantially lower resistance value than the fixed resistance element 9. As shown in Fig. 18, the conductor 35 is formed on the side of the fixed resistance element 9 by using the sputter method and the coating method.

The conductor 35 is formed of four divisional path pieces 35a to 35d which is connected to the fixed resistance element 9 in the longitudinal direction (Y direction in the figure) with a gap, and the common path piece 35e which connects the divisional path pieces between 35a to 35d respectively. As shown in Fig. 5A, by connecting the side of the fixed resistance element 9, since the current flows through inside the conductor 35 having a low resistance among the fixed resistance element 9 in a parallel and the conductor 35, the resistance value R1 reduces with respect to that before forming the conductor 35. As shown in 18, when the resistance value R1 departs from the allowable range about the resistance value R2 in a state where the conductor 35 is connected as shown in Fig. 18, an adjustment of the resistance ends. On the other hand, when the resistance value R1 becomes under the resistance value R2 and departs from the allowable range, a process in Fig. 19 is performed.

In addition, in the embodiment, when the conductor 35 of Fig. 18 is connected, it is preferable that the resistance value R1 be decreased by the connection of the conductor 35 and then the process shown in Fig. 19 be performed after the above-mentioned process than that the resistance value R1 is set to the deviation amount within the allowable range of the resistance value R2.

In a process of Fig. 19, a part of the conductor 35 is cut in accordance with a required increased amount of resistance and accordingly the current path length of the conductor 35 in the longitudinal direction (Y direction in the figure) is shortened. In fig 18, although the current path length is L2 in the longitudinal direction of the conductor (Y direction in the figure), the current path length in the longitudinal direction of the conductor 35 (Y direction in the figure) is shortened by cutting 35e1 which is a part of the common path piece 35e in Fig. 19 by using laser and so on. As a result, the resistance value R1 increases from the state of Fig. 18. When the resistance R1 is within the allowable range of the resistance R2 by cutting the 35e1 which is a part of the common path piece 35e, the adjusting the resistance value ends. The part of the conductor 35 is cut, and the current path length in the longitudinal direction (Y direction in the figure) is shortened, thereby increasing the resistance value R1 at the time other than the allowable range.

In addition, in Fig. 18, the divisional path pieces 35a to 35d are four. However, the divisional path pieces may have a high-resistance value with high precision by adding the divisional path pieces more.

After adjusting the resistance value, the substrate 60 is cut in each set. Alternatively, it is possible to adjust the resistance value from the substrate 60 after cutting in each set.

In addition, in the method of manufacturing the magnetic sensor shown in Figs. 7 and 8, when the resistance value R1 is larger than the resistance R2 after the process of Fig. 17, the part of the fixed resistance element 9 is removed by the milling method and so on as much as a required size in accordance with the resistance value of the resistance value R1, and the conductor 36 having substantially a low-resistance such as Cu is filled in the removed position by the sputter method, the plating method and the like.

In the milling process of the element, since there is a possibility that the magnetoresistance element 8 perform the milling process, degrade a milling surface may be damaged. Accordingly, in the element forming process, it is preferable that the resistance of the fixed resistance element 9 be larger than that of the magnetoresistance element 8 to, for example, so that the longitudinal length of the fixed resistance element 9 is formed to be longer that that of the magnetoresistance element 8.

In addition, when the magnetoresistance element 8 is performed by a milling process or the fixed resistance element having the magnetoresistance element 50 shown in Fig. 11 is mounted on the element base 7, one of the magnetoresistance element 8 or the magnetoresistance element 50 has to perform the milling process. However, although the length of the element is shortened by the milling process, it is possible to suppress a disperse of the coercive Hc or the interlayer coupling magnetic field Hin. Accordingly, the hysteresis characteristic may not vary.

In the above-mentioned embodiment, the magnet 5, M1, M2 is not included in the magnetic sensor 4, 61, but the magnetic sensor 4, 61 can be defined including the magnet 5, M1, M2.

In addition, although the magnetic sensor 4, 61 are provided on the element base 7 where the magnetoresistance element 8 and the fixed resistance is provided by one, the magnetic sensor 4, 61 may have two bridge circuit in which one magnetoresistance element 8 and one fixed resistance is provided (that is, two magnetoresistance elements and two fixed resistances). In addition, the magnetic sensor 4, 61 may have a configuration in which the magnetoresistance element 8 is provided by one.

In addition, although the magnetic sensor 4 of the embodiment is used for detection opening and closing states of the foldable cellular phone 1, the magnetic sensor 4 can be used for detection of a game device. In addition, the magnetic sensor 4, 61 of the embodiment can be used as a sensor for detecting a rotational angle like a throttle positioning sensor, an encoder, a geomagnetic sensor, and the like (direction sensor).

It is optional whether a bias magnetic field is applied to the magnetoresistance element. The bias magnetic field may be not supplied to the free magnetic layer constituting the magnetoresistance element. In addition, the magnetoresistance element may be also an AMR element and a TMR element other than a GMR element.

## Claims

1. A magnetic sensor comprising:
at least one magnetoresistance element provided on an element base;
at least one fixed resistance element provided on the element base; and
terminal portions provided on both sides in a longitudinal direction of the magnetoresistance element and on both sides in a longitudinal direction of the fixed resistance element,
wherein a conductor is connected to at least one element of the magnetoresistance element and the fixed resistance element so as to adjust a resistance value between the terminal portions.

2. The magnetic sensor according to Claim 1, wherein the conductor is connected to an end of a high-resistance element which is one of the magnetoresistance element and the fixed resistance element having a high resistance value and the conductor is formed in a shape in which a current path length is shortened in the longitudinal direction by cutting.

3. The magnetic sensor according to Claim 2, wherein the conductor includes at least three cuttable divisional path pieces which come in contact with the high-resistance element with gaps in the longitudinal direction therebetween, and a cuttable common path piece connecting the cuttable divisional path pieces to each other.

4. The magnetic sensor according to Claim 3, wherein the gaps in the longitudinal direction between the divisional path pieces are different from each other.

5. The magnetic sensor according to Claim 3 or 4, wherein a part of a high-resistance element which is one of the magnetoresistance element and the fixed resistance element having a high resistance value is removed to shorten in the longitudinal direction a length is shortened its length in a longitudinal direction and the conductor is provided in the removed part.

6. The magnetic sensor according to any of Claims 1 to 5, wherein the magnetoresistance element and the fixed resistance element include an anti-ferromagnetic layer, a plurality of magnetic layers, a non-magnetic layer, and a protection layer serving as an uppermost layer,
wherein the magnetoresistance element includes a fixed layer which has at least one magnetic layer and of which magnetization direction is fixed and a free layer which has the other magnetic layers and of which magnetization direction varies with an external magnetic field, the non-magnetic layer is interposed between the fixed layer and the free layer, and the anti-ferromagnetic layer is formed in contact with a surface opposite to the surface of the fixed layer where the non-magnetic is formed; and
wherein in the fixed resistance element, the at least one magnetic layer is formed in contact with the anti-ferromagnetic layer, and the magnetization directions of all the magnetic layers are fixed.

7. The magnetic sensor according to any of Claims 1 to 6, wherein the magnetoresistance element and the fixed resistance element have an anti-ferromagnetic layer, a fixed layer which is formed in contact with the anti-ferromagnetic layer and of which a magnetization direction is fixed, and a free layer which is opposed to the fixed layer with a non-magnetic layer therebetween, and of which the magnetization directions vary with the external magnetic field, and
wherein a first interlayer coupling magnetic field Hin acting between the free layer and the fixed layer of the fixed resistance element is larger than a second interlayer coupling magnetic field Hin acting between the free layer and the fixed layer of the magnetoresistance element.

8. A method of manufacturing a magnetic sensor, the method comprising the steps of:
(a) forming a plurality of sets, each of which includes at least a magnetoresistance element and a fixed resistance, on a substrate and,
(b) forming terminal portions on both sides in a longitudinal direction of the magnetoresistance element and on both sides in the longitudinal direction of the fixed resistance element,
(c) connecting a conductor to a high-resistance element which is one of the magnetoresistance element and the fixed resistance element having a high resistance value so as to set a resistance value between the terminal portions connected to the high-resistance element within an allowable range of a resistance value between the terminal portions connected to a low-resistance element.
(d) cutting each set out of the substrate, between the process (b) and the process (c), or after the process (c).

9. The method according to Claim 8, wherein in the process (c), the conductor connected to the high-resistance element has such a shape that a current path length may be shortened in the longitudinal direction by cutting:

10. The method according to Claim 9, wherein the process (c) includes a first sub-process of setting the resistance value between the terminal portions connected to the high-resistance element to be lower than the resistance value between the terminal portions connected to the low-resistance element at the time of connecting the conductor, and a second sub-process of cutting a part of the conductor to shorten a current path length in the longitudinal direction of the conductor and thus to increase the resistance value between the terminal portions connected to the high-resistance element,
wherein the second sub-process is repeated until the resistance value between the terminal portions connected to the high-resistance element is within the allowable range.

11. The method according to Claim 10, wherein the conductor has at least three cuttable divisional path pieces in contact with the high-resistance element with gaps therebetween in the longitudinal direction and a cuttable common path piece connecting the divisional path pieces, and the divisional path pieces or the common path piece is cut or the divisional path pieces and the common path piece are cut in the second sub-process of the (c) process.

12. The method according to Claim 11, wherein the gaps in the longitudinal direction between the divisional path pieces have different lengths in the longitudinal direction, a cutting position of the divisional path piece or the common path piece are determined or cutting positions of the divisional path piece and the common path piece are determined in accordance with an increased amount of resistance value necessary for the second sub-process of the process (c).

13. The method according to any of Claims 8 to 12, wherein in the process (c), a part of the high-resistance element is removed to shorten a length in the longitudinal direction of the high-resistance element and the conductor is formed in the removed part to decrease a resistance value between the terminal portions connected to the high-resistance element lower than the resistance value before removing the part of the high-resistance element.
